# EUROPEAN PATENT APPLICATION

(11) **EP 2 216 807 A2**
(43) Date of publication of application: **11.08.2010**
(21) Application number: 09004869.5
(22) Date of filing: 02.04.2009
(51) Int. Cl.: H01L 21/48, H01L 23/367

(54) **Heat-dissipation apparatus**

(30) Priority: 10.02.2009 TW 98201904 U
(71) Applicant: Giga-Byte Technology Co., Ltd., Hsin-Tien Taipei County (TW)
(72) Inventor: Huang, Shun Chih, Hsin-Tien Taipei County (TW)
(74) Representative: Brandenburger, Karin

(57) **Abstract**

A heat-dissipation apparatus comprises a first heat conductive plate, a second heat conductive plate which bonds the first conductive plate, and a fin assembly. The first heat conductive plate has a plurality of first protrusions and a plurality of passageways interposed between the first protrusions. The second heat conductive plate has a plurality of second protrusions, and these second protrusions wedge in the passageways on the first conductive plate to interpose between the first protrusions. The fin assembly has a plurality of individual heat-dissipation fins, and part of each heat-dissipation fin is sandwiched tightly between the first protrusion and the second protrusion. The heat-dissipation apparatus is simply with punching to complete assembling and further to be provided with excellent efficiency

## Description

### BACKGROUND OF THE INVENTION

### Field of the Invention

The present invention generally relates to the structure of making a heat-dissipation apparatus, and more particular, relates to simply with the method of punching for assembling a heat-dissipation apparatus completely.

### Description of the Related Art

For conventional heat-dissipation apparatus, disclosed in Taiwan Patent Publication number 544081 for instance, mainly is composed with a fin assembly and a bottom plate and using solder paste or heat conduction glue to combine together. The issue that the structure exists for long term needs to be improved will be given hereinafter.

Either solder paste or heat conduction glue, its conduction rate is lower than aluminum or copper which is used to make the fin assembly and bottom plate, The process of the heat conduction, the heat sequential passing from the bottom plate, solder paste or heat conduction glue, fin assembly, much heat is kept at the solder paste or heat conduction glue and there's not enough time for conducting to the fin assembly, as a result, there is a great effect to the heat dissipation efficiency of the whole heat-dissipation apparatus.

To each heat dissipation plate on the fin assembly, in fact, only a small and narrow area combines with the bottom plate by the solder paste or heat conduction glue. This means that each heat dissipation plate absorbs heat from the bottom plate via a tiny area, and it also affects the heat dissipation efficiency of the whole heat-dissipation apparatus.

Secondly, to merely use heat conduction glue to bond the fin assembly and bottom plate together is not good enough in the stability, and which makes the fin assembly probably has the possibility of loosening.

Besides, the fin assembly and the bottom plate needs to have surface processing process (electroplate), solder paste coating process, and reflow processing process to combine together. More processing process needed, more cost increased.

Although the heat-dissipation module disclosed in Taiwan Patent (Utility Model) number M337724 can solve some problem above-mentioned, however, wherein the sandwich copper units need screwing work, which is time-consuming and effort-requiring. Furthermore, these sandwich copper units can't make a complete bottom surface for contacting the heat source.

### BRIEF SUMMARY OF THE INVENTION

The present invention provides a method of simply with punching to complete assembling the heat-dissipation apparatus with excellent heat-dissipation efficiency.

In detail, the heat-dissipation apparatus in accordance with the present invention comprises a first heat conductive plate, a second heat conductive plate which stacked (combined) with the first conductive plate, and a fin assembly. The first heat conductive plate has a plurality of first protrusions on same side and a plurality of passageways interposed between the first protrusions. The second heat conductive plate has a plurality of second protrusions on same side and these second protrusions wedge in the passageways on the first conductive plate to interpose between the first protrusions. The fin assembly has a plurality of individual heat-dissipation fins which stand separately on the first heat conductive plate, and each heat-dissipation fin is sandwiched tightly between the first protrusion and the second protrusion.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

The present invention will become more fully understood from the detailed description given hereinbelow and the accompanying drawings which are given by way of illustration only, and thus are not limitative of the present invention, and wherein
FIG. 1 is a breakdown perspective view in accordance with a preferred embodiment of the present invention;
FIG. 2 is a partial section view of the first heat conductive plate in accordance with a preferred embodiment of the present invention;
FIG. 3 is a perspective view of combining with a circuit board in accordance with a preferred embodiment of the present invention;
FIG. 4 is an A-A section view derived from FIG. 3;
FIG 5 is a schematic view of assembling processes in accordance with a preferred embodiment of the present invention;
FIG. 6 is a perspective view of the second heat conductive plate In accordance with an embodiment of the present invention;
FIG. 7 is a perspective view of the other first heat conductive plate In accordance with an embodiment of the present invention;
FIG. 8 is a partial detail view of the other second heat conductive plate;
FIG. 9 is a partial detail view of the other second heat conductive plate in accordance with an embodiment with the present invention;
FIG. 10 is a schematic view of assembly of the other first heat conductive plate and the other second conductive plate;
FIG. 11 is a section view of assembly of the other first heat conductive plate and the other second conductive plate.

### DETAILED DESCRIPTION OF THE INVENTION

The present invention will now be described in detail with reference to the accompanying drawings, wherein the same reference numerals will be used to identify the same or similar elements throughout the several views. It should be noted that the drawings should be viewed in the direction of orientation of the reference numerals.

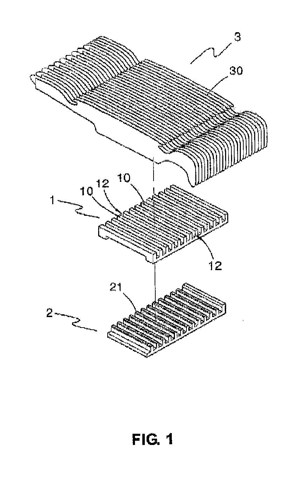

Referring to FIG. 1, an embodiment of the present invention, wherein the heat-dissipation apparatus comprises a first heat conductive plate 1, a second heat conductive plate 2 and a fin assembly 3. The first heat conductive plate 1 has a plurality of first protrusions 10 on same side, a plurality of passageways 12 interposed between the first protrusions 10. The second heat plate 2 has a plurality of second protrusions 21 on same side. The fin assembly 3 has a plurality of heat-dissipation fins 30.

Each component above-mentioned can choose the same or different heat conduction material, such as aluminum or copper. It would be best to use all same material, like aluminum, for the convenience of manufacture. And further, the first heat conductive plate 1 and the second heat conductive plate 2 can electroplate in different color or can print with different color or prints.

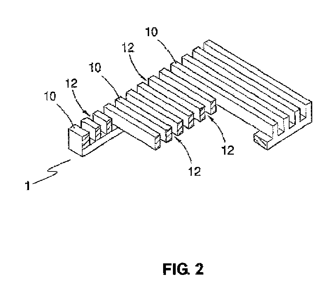

Referring to FIG. 2, the middle structure of section of each passageway 12 on the first conductive plate 1 are all hollow-through, except small part on two sides.

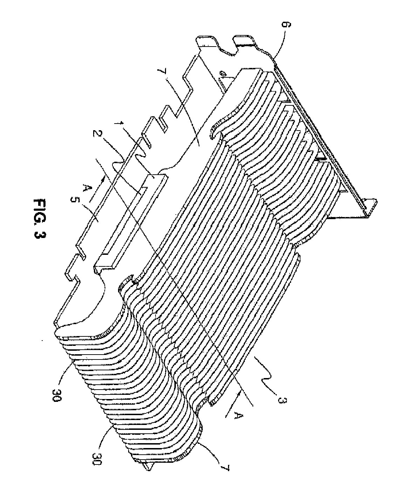

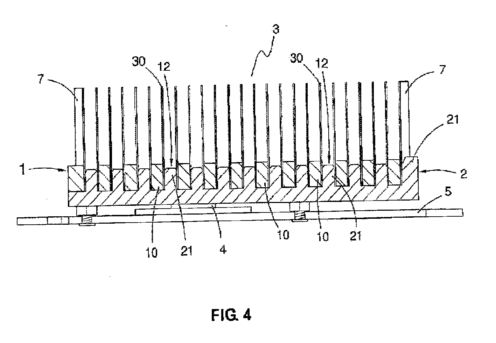

Referring to FIG. 3 and FIG. 4, wherein present the arrangement of the heat-dissipation apparatus and its utilization with a circuit board 5. The first heat conductive plate 1 and the second heat conductive plate 2 is stacked (or combined) tightly together. The second protrusions 21 wedge separately In the passageways 12 on the first conductive plate 1 and therefore interpose with the first protrusions 10. And, the heat-dissipation fins 30 of the fin assembly 3 stand on the first heat conductive plate 1 and the second heat conductive plate 2, and part of each separate heat-dissipation fin 30 is sandwiched tightly between interposed the first protrusion 10 and the second protrusion 21. Wherein there are a backboard 6 and two baffle plates 7 to make the frame around the fin assembly 3.

When the element 4, like a central processing unit (CPU), on the circuit board 5 works to cause waste heat, the waste heat will conduct from bottom of the second heat conductive plate 2 to the second protrusions 21 and then to the first protrusions 10 on the first conductive plate 1, so each heat-dissipation fin 30, which is sandwiched between a pair of the first protrusion 10 and the second protrusion 21, can absorb and then dissipate the waste heat from every pair of the first protrusion 10 and the second protrusion 21.

Because every pair of the first protrusion 10 and the second protrusion 21 contact the sandwiched heat-dissipation fin 30 with large area, the heat-dissipation efficiency is quite excellent for the heat-dissipation apparatus made in accordance with the present invention.

Moreover, the second conductive plate 2 can cooperate with the ready-made heat pipe further, and the fin assembly 3 can cooperate with the ready-made fan. Each of them can increase the efficiency to the heat-dissipation apparatus of the present invention further.

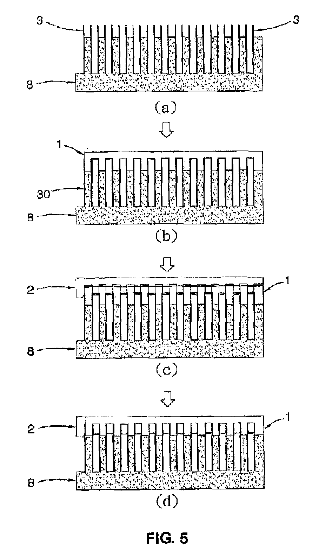

Referring to FIG. 5 is the assembling process of the heat-dissipation apparatus in accordance with the present invention. According to FIG. 5 (a), place the fin assembly 3 on the mold 8. And then, according to FIG. 5 (b), place the first heat conductive plate 1 on mold 8. And then. according to FIG. 5 (c), place the second heat conductive plate 2 on the first heat conductive plate 1. To the final, using punch machine to punch the second heat conductive plate 2 for tightly stacking (combining) the second heat conductive plate with the first heat conductive plate together, displayed as FIG. 5 (d). Then, the assembling of the heat-dissipation apparatus in accordance with present Invention has been completed. The heat-dissipation apparatus token out from the mold 8 is just like the one shown in FIG. (3) and FIG. (4).

The first heat conductive plate 1, the second heat conductive plate 2, and fin assembly 3 have individual structure above-mentioned, so as to use the punch machine to assemble the complete heat-dissipation apparatus speedily as shown in FIG. 5. Compare with the conventional technique, the present invention is no need of welding or screwing, and has the advantage of time-saving, effort-saving, and low-cost.

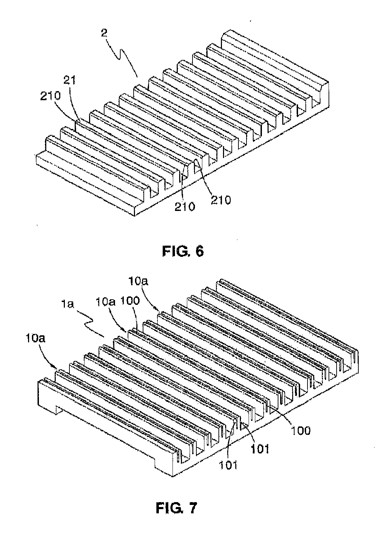

Referring to FIG. 6, a chamfer 210 is formed along each of two relative long sides on the top of the second protrusion 21. Therefore, during the punch process. above-mentioned, the second protrusion 21 can wedge in the passageway 12 on the first heat conductive plate 1 more smoothly.

Referring to FIG. 7, the other first heat conductive plate 1a resembles the first heat conductive plate 1 above-mentioned, but differs in a V-shape passageway 100 which is formed in each of the first protrusion 10a. The length of V-shape passageway 100 is same to the length of the first protrusion 10a, and the depth of V-shape passageway 100 is close to the bottom of the first protrusion 10a. For the reason, the V-shape passageway 100 divides the first protrusion 10a into two branches 101.

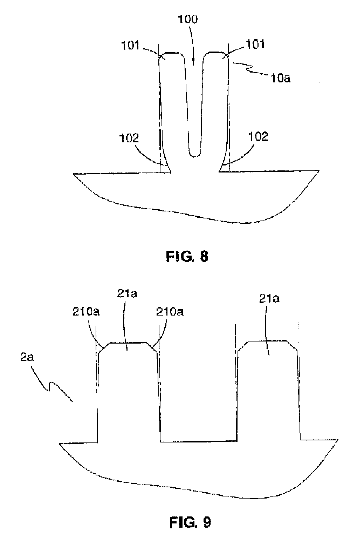

Referring to FIG. 8, a chamfer 102 is formed along each of two relative long sides on the bottom of the first protrusion 10a., and two branches 101 on each the first protrusion 10a lean outward slightly.

Referring to FIG. 9, the other second heat conductive plate 2a is similar to the second heat conductive plate 2 above-mentioned, but differs In that each second protrusion 21a gradually narrows down from the bottom to the top. Furthermore, the chamfers 210a are also formed on the second protrusion 21a, just same to the chamfers 210 above-mentioned.

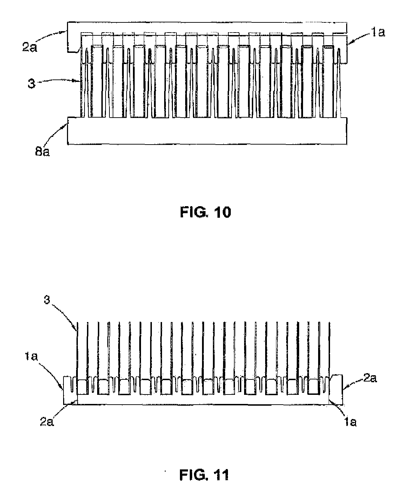

Referring to FIG. 10, the arrangement of the first heat conductive 1a, the second heat conductive 2a and fin assembly 3 are put on the mold 8; wherein the processes are same to FIG. 5 (a)- FIG. 5 (c).

Referring to FIG. 11, the heat-disslpation apparatus is assembled with the first heat conductive plate 1a, the second heat conductive plate 2a, and the fin assembly 3; wherein by using punch machine above-mentioned for assembling the heat-dissipation apparatus and the process is same to FIG. 5 (d). What needs to be pointed out is when the second protrusion 21a separately wedges in the passageways 12a, each of two branches 101 on the first protrusion 10a will be pushed inwards to become straight by wedging the corresponding second protrusion 21a.

With the design of the first heat conductive plate 1a and the second heat conductive plate 2a above-mentioned, so, the first heat conductive plate 1a and the second heat conductive 2a can not only stack (combine) together smoothly but also eliminate the tolerance occurring during manufacturing. Finally, for this reason which makes both the first heat conductive 1a and the second heat conductive 2a enable to stack (or combine) together tightly and enable each heat-dissipation fin 30 of fin assembly 3 to be sandwiched tightly between every pair of the second protrusion 21a and the first protrusion 10a.

While the invention has been described by way of example and in terms of the preferred embodiment, it is to be understood that the invention is not limited to the disclosed embodiments, and it will be obvious that the same may be varied in many ways. Such variations are not to be regarded as a departure from the spirit and scope of the invention, and all such modifications as would be obvious to one skilled in the art are intended to be included within the scope of the following clams.

## Claims

1. A heat-dissipation apparatus, comprising:
a first heat conductive plate, having a plurality of first protrusions placed on the same side and a plurality of passageways interposed between said first protrusions;
a second heat conductive plate, stacked (or combined) with said first heat conductive plate, having a plurality of second protrusions on same side, and said second protrusions wedge into said passageways of said first heat conductive plate to interpose between said first protrusions; and
a fin assembly, having a plurality of heat-dissipation fins standing with said first heat conductive plate and said second heat conductive plate, and a part of each heat-dissipation fin tightly placed in between interposed said first heat conductive plate and said second heat conductive plate.

2. The heat-dissipation apparatus as claimed in claim 1, wherein there is a chamfer along each of two relative long sides on the top of said second protrusion.

3. The heat-dissipation apparatus as claimed in claim 1, wherein each said first protrusion forms a V-shape passageway and the length of said V-shape passageway is equal to the length of said first protrusion, and the depth of said V-shape passageway is close to the bottom of said first protrusion.

4. The heat-dissipation apparatus as claimed in claim 3, wherein there Is a chamfer along each of two relative long sides at bottom of said first protrusion.

5. The heat-dissipation apparatus as claimed in claim 4, wherein the width of each said second protrusion gradually narrows down from the bottom to the top, and there is a chamfer along each of two relative long sides on said second protrusion.
